(19) Europäisches Patentamt
European Patent Office
Office européen des brevets

(11) EP 1 947 464 A1

(12) EUROPEAN PATENT APPLICATION

(43) Date of publication:
**23.07.2008 Bulletin 2008/30**

(21) Application number: **07425028.3**

(22) Date of filing: **22.01.2007**

(51) Int Cl.:
***G01R 1/24*** *(2006.01)* ***G01R 21/01*** *(2006.01)*
***G01R 21/10*** *(2006.01)* ***G01R 21/12*** *(2006.01)*
***H01P 5/00*** *(2006.01)*

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **Nokia Siemens Networks S.p.A.**
**20126 Milano (IT)**

(72) Inventors:
- **Amadio, Stefano**
  **20062, Cassanod'Adda (MI) (IT)**
- **Marconi, Franco**
  **20052 Monza (MI) (IT)**
- **Zingirian, Alessandro**
  **20149 Milano (IT)**

(74) Representative: **Giustini, Delio et al**
**Nokia Siemens Networks S.p.A**
**Viale dell'Innovazione, 3**
**20126 Milano (IT)**

# (54) Power detector insensitive to standing waves of a microwave signal transmitted by a mismatched waveguide

(57) A Microwave power detector is coupled to a rectangular waveguide with a sidewall replaced by an uniform metallization on a bottom face of a FR4 dielectric substrate screwed to the waveguide. Two irises aligned along a common line parallel to the lines of magnetic field inside the waveguide, are etched inside the metallization acting as sidewall. Two microstrips are laid down on the upper face of dielectric substrate, each one intersects a respective iris orthogonally in the middle point. The two microstrips are connected to ground at one end immediately beyond respective irises, and are spaced substantially quarter wave apart calculated at the centre of the operating frequency band (15-18 GHz). Besides, the two microstrips are quarter wave long in order to show an open circuit impedance at the other end connected to a respective voltage detector including a Schottky diode in series to a resistor. At midpoint of the connection line between the two serially connected voltage detectors a voltage Vsum is read with high impedance. Vsum is the average of the two detected voltages, it is indicative of the signal power travelling across the waveguide and it results substantially insensitive of standing-wave pattern (fig.12).

FIG. 8A
Generator
5
7
8
10
BTL
VD1
VD2
Vsum
Direct wave
Reflected wave
ρ
Load
5'
8'
Voltage Detector 1
λ/4
Voltage Detector 2
Transmission line

EP 1 947 464 A1

## Description

### FIELD OF THE INVENTION

The present invention relates to the field of microwave power detection, and more precisely to a microwave power detector insensitive to standing-wave pattern of a mismatched waveguide transmitted microwave signal. As known, power detection is directly related to voltage detection at the ends of a known resistor; being $V$ the mean detected voltage and P the average power across the waveguide, it results in the linear law relationship of a diode detector: $P = V^2/R$ or $\left(V = \sqrt{P \cdot R}\right)$.

### BACKGROUND ART

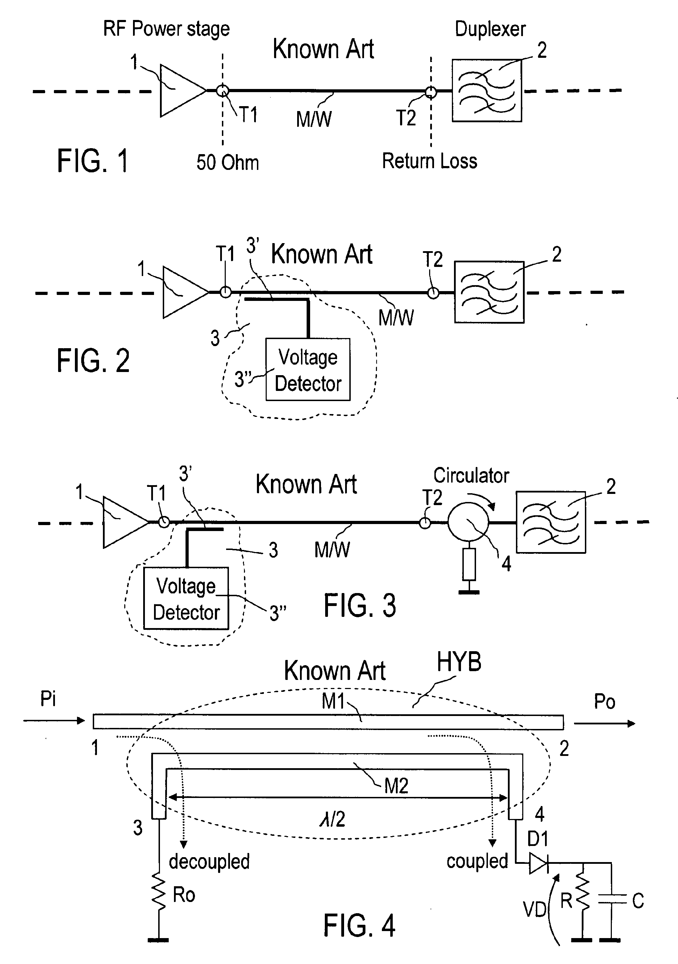

**Fig.1** schematizes a final part of a microwave transmitter before the antenna system (not shown). This arrangement comprises a power stage 1 connected to a first end T1 of a transmission line M/W (either microstrip or waveguide) with the other end T2 connected to an input port of a duplexer filter 2. The configuration of fig.1 is used in a lot of radio transmission systems, e.g.: line-of-sight radio links, point-to-point or point-to-multipoint multipath transmission systems like mobile radio networks or MAN/LAN 802.16 networks, etc. The present invention is valid both for wireless or wired transmission systems. A general problem of these systems is that of knowing by a control unit the exact power transmitted from the power stage, in order to perform a procedure called Remote Transmit Power Control (RTPC) that is needed to regulate the power level inside the foreseen dynamic. In line of principle the transmitted power level should be read by placing a detector in a suitable position along the M/W transmission line close to the power stage 1, but this is not enough as the following theory will demonstrate.

Without limitation, the characteristic impedance $Z_O$ of line M/W is 50 Ohm. The input impedance of the duplexer filter 2 represents the load impedance $Z_L$ at the end T2 of transmission line M/W. If $Z_L$ is matched to 50 Ohm of the line the RF power at the end T2 is not reflected back towards T1, otherwise a power fraction only depending on $Z_L$ is reflected back towards the amplifier 1. More in general, saying $\gamma = \alpha + j\beta$ the propagation constant of the travelling wave along the line M/W, and adopting the phasor notation hiding the time-dependent term $e^{-j\omega t}$, and using the variable $z$ to indicate distances from the load $Z_L$ located at z = 0, if a voltage wave $V^+e^{-\gamma z}$ with an associated current $I^+e^{-\gamma z}$ is incident on the termination load, a reflected voltage $V^-e^{\gamma z}$ with a current $-I^-e^{\gamma z}$ will, in general, be created. Hence on the load $Z_L$ it results $V = V^+ + V^- = V_L$ , $I = I^+ - I^- = I_L$ and by definition $Z_L = V_L/I_L$ . The ratio of $V^-$ to $V^+$ is usually described by a complex voltage reflection coefficient $\Gamma = \dfrac{V^-}{V^+}$ , and the quantity $\overline{Z}_L = Z_L/Z_0$ is defined the normalized load impedance. After a certain handling we obtain: $\Gamma = \dfrac{\overline{Z}_L - 1}{\overline{Z}_L + 1}$ that confirms the absence of voltage reflection for $Z_L = Z_0$ . Supposing for a moment a lossless line, it results $\gamma = j\beta$, where $\beta = 2\pi/\lambda$, and $\lambda$ is the wavelength of the fundamental propagation mode in the transmission line. In the absence of reflection, the magnitude of the voltage along the line is a constant (phasor) equal to $|V^+|$. When a reflected wave also exists, the incident and reflected waves interfere to produce a standing-wave pattern along the line. The voltage at any point on the line (z < 0) is given by $V = V^+e^{-j\beta z} + \Gamma V^+e^{j\beta z}$ and has a magnitude given by $|V| = |V^+||1+\Gamma e^{j2\beta z}| = |V^+|^1\ 1+\Gamma e^{-j2\beta l}|$ where $l = -z$ is the positive distance measured from the load toward the generator (from T2 to T1 in fig.1). Let $\Gamma = \rho e^{j\theta}$ and, consequently, $\rho = |\Gamma|$ , after a trigonometrical handling we obtain:

$$|V| = |V^+|\left[(1+\rho)^2 - 4\rho\sin^2\left(\beta l - \frac{\theta}{2}\right)\right]^{\frac{1}{2}} \qquad \text{Eq. (1).}$$

This result shows that $|V|$ oscillates back and forth between maximum values of $|V^+| \cdot (1+\rho)$ when $\beta l - \theta/2 = n\pi$ and minimum values of $|V^+| \cdot (1-\rho)$ when $\beta l - \theta/2 = n\pi + \pi/2$ , where n is an integer. Successive maxima are spaced at a distance $\lambda/2$ and the same for successive minima whereas the distance between a maximum and the nearest minimum is $\lambda/4$. The ratio of the maximum line voltage to the minimum line voltage is called the voltage standing-wave ratio S; thus:

$$S = \frac{|V^+|(1+\rho)}{|V^+|(1-\rho)} = \frac{(1+\rho)}{(1-\rho)} \quad \text{Eq. (2).}$$

In the case of lossy line with attenuation constant $\alpha$, the previous equation hold except that $j\beta$ must be replaced by $\alpha + j\beta$ . In application with waveguides $\alpha$ is so small that for the short lengths the neglect of $\alpha$ is justified. The effect of $\alpha$ shall be considered when high losses FR4 substrates are used. Clearly the presence of an attenuation constant $\alpha$ does not affect the definition of the voltage reflection coefficient $\Gamma_L$ for the load connected at the end T2. However, at any other point a distance $l$ toward the end T1, the reflection coefficient is now given by: $\Gamma(l) = \Gamma_L e^{-2j\beta l - 2\alpha l}$. As $l$ is increased, $\Gamma$ decreases exponentially until, for large $l$, it essentially vanishes.

The theory developed above demonstrates that in wave guides (or transmission lines in general), limitedly to an ideal case without any mismatch and losses, the voltage module is constant along the transmission line, so that the position of a detector is indifferent, but this is only an exception because the real behaviour of the system of fig.1 is very different from the ideal and by way of mismatching a standing-wave pattern is generally present. In this case the microwave detector provides a voltage signal strongly dependent from the nodes and antinodes position on the line in respect to the detector position. Nodes and antinodes move on the line as the frequency or terminal impedances change and, as a consequence, the detected voltage is not representative of the available power.

**TABLE 1** reports some comparative values of the most representative parameters of mismatch.

| Return Loss (dB) | Reflection coefficient (ρ) | Standing Wave Ratio (dB) |
|---|---|---|
| 0 | 1 | ∞ |
| 6 | 0.5 | 9.5 |
| 12 | 0.25 | 4.4 |
| 18 | 0.125 | 2.18 |
| 24 | 0.063 | 1.06 |
| ∞ | 0 | 1 |

From Table 1 we see that as $\rho$ approaches the ideal null value as the logarithmic return loss increases and the SWR approaches the unit value.

Up to now the problem of a reliable power detection has been solved by the use of a high directivity directional coupler inclusive of a voltage detector able to detect the travelling wave toward the load (duplexer 2) and not the one in opposite direction. Unfortunately the high directivity directional coupler, in principle, is easy to do in wave guide but in practice not used for its considerable dimension, difficult working and assembling time. Microstrip couplers, instead, exhibit poor directivity unless made half wave long, but, as a consequence, noteworthy insertion loss will be produced if a standard high loss dielectric substrate (e.g. FR4) is used. Finally, low directivity directional couplers quarter wave long is allowed, but the use of an isolator is mandatory in order to avoid the reflected wave. In this case the isolators cost has to be taken into consideration. The two options are depicted in **fig.2,** for half wave, and in **fig.3** for quarter wave implementations. In these figures we see a power detection circuit 3 comprising a directional coupler 3' coupled to the transmission line M/W nearby its end T1 for capturing a small fraction of the transmitted signal that is forwarded to a voltage detector 3". In **fig.3** a circulator 4 is coupled between the end T2 of transmission line M/W and the input of duplexer filter 2.

**Fig.4** shows a realization of the power detector circuit 3 with microstrip coupler. This power detector includes a 4-port directional coupler HYB (hybrid) connected to some discrete devices. The hybrid HYB is constituted of two half wave parallel microstrips M1, M2 opportunely spaced to each other so as to be coupled; a first microstrip being a tract of the transmission line M/W (microstrip) in proximity of the end T1. The four ports are numbered as 1, 2, 3, 4. Port 1 is located near to the end T1; port 2 is $\lambda/2$ apart on microstrip M/W; port 3 is an end of the microstrip M2 at the same side of port 1, and port 4 is $\lambda/2$ apart on microstrip M2. Port 3 is connected to a load resistor Ro = 50 Ohm, the other end of resistor Ro is grounded. Port 4 is connected to the anode of a diode D1 whose cathode is connected to the parallel of a resistor R and a capacitor C both grounded at the other end. The diode D1 connected to R and C constitutes a rectifying circuit for the microwave signal able to generate a rectified voltage VD across resistor R. The capacitor C is charged to the average rectified voltage. If the hybrid HYB works ideally, port 3 is decoupled from the transmitted signal Pi and port 4 is coupled instead. Dually, port 4 is decoupled from the reflected signal present at port 2, and port 3 is coupled so as to dissipate the reflected signal on the load resistor Ro. In the reality a small power ratio of signal Pi is also coupled to the isolated port 3 and a small power ratio of the reflected signal is also coupled to port 4. The spurious couplings worsen the directivity of the voltage detector 3 and hence the truthfulness of detection.

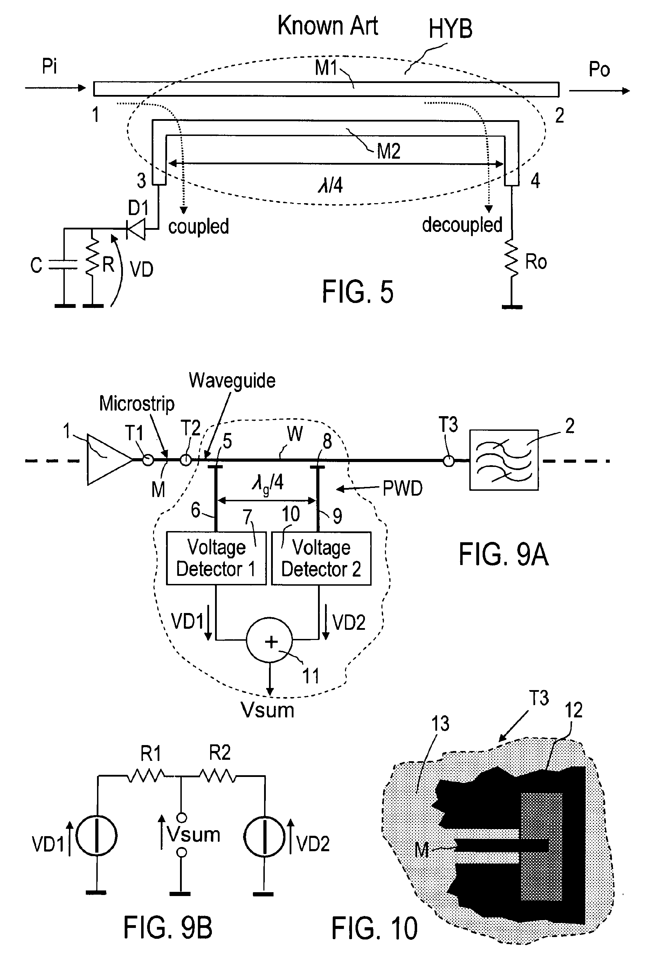

**Fig.5** shows an alternative power detector circuit 3 that differs from the one illustrated in **fig.4** by way of quarter wave length of microstrips M1, M2 instead of half wave. In this case port 4 and port 3 invert their rules, so the rectifying circuit D1, R, and C is connected to port 3 and Ro is connected to port 4.

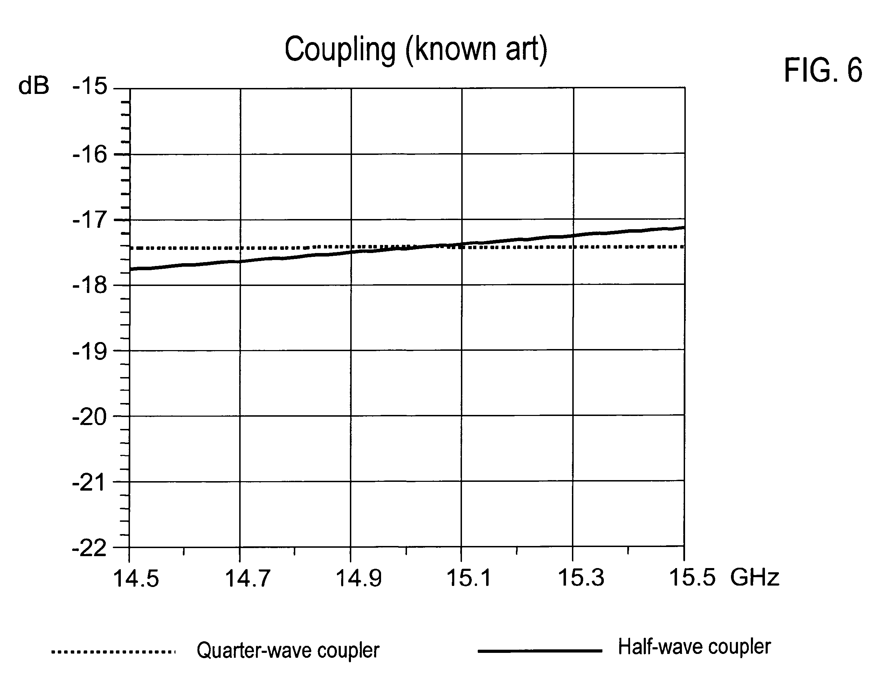

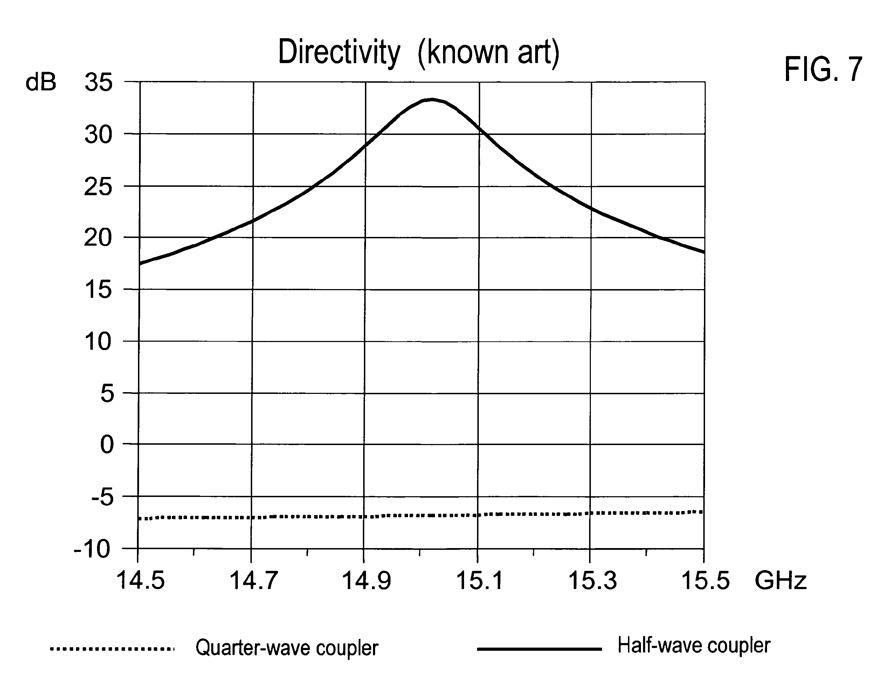

Comparative curves of coupling and directivity versus frequency of the two directional couplers depicted in **figures 4** and **5** are shown in **figures 6** and **7.** With reference to **fig.6,** we see that coupling is nearby the same for the two types of directional couplers but a large gap exists between the directivity curves shown in **fig.7,** being the quarter wave coupler poor directive, and the use of circulator is plenty justified.

A useful tool for studying directional couplers and microwave n-port circuits in general is the so-called scattering matrix S having the following representation

$$\begin{bmatrix} V_1^- \\ V_2^- \\ V_3^- \\ V_4^- \end{bmatrix} = \begin{bmatrix} S_{11} & S_{12} & S_{13} & S_{14} \\ S_{21} & S_{22} & S_{23} & S_{24} \\ S_{31} & S_{32} & S_{33} & S_{34} \\ S_{41} & S_{42} & S_{43} & S_{44} \end{bmatrix} \begin{bmatrix} V_1^+ \\ V_2^+ \\ V_3^+ \\ V_4^+ \end{bmatrix} \qquad (3)$$

where apex - and $^+$ indicate signals outgoing from or incoming to two transmission lines respectively connected to the ports indicated by subscript 1, 2, 3, and 4. Referring to the directional coupler of **fig.4**, ports 1 an 2 are the input and output port, respectively, while ports 3 and 4 are the isolated and coupled ports, respectively.

## SUMMARY AND ADVANTAGES OF THE INVENTION

The object of the present invention is that to overcome the defects of microwave power detector of the prior art discussed with reference to the preceding figures, and indicate a microwave power detector insensitive to the standing-wave pattern, as far as possible. The insensitive microwave power detector should be applicable to a transmission line in general, either a closed-type waveguide or an open-type line such as microstrips or balanced coplanar lines.

The invention achieves said object by providing a microwave detector of the signal power travelling across a transmission line, as disclosed in claim 1.

According to the invention, the microwave power detector includes:

- first and second coupling means spaced along a coupled transmission line substantially quarter wave apart at the centre of the operating frequency band;
- first and second voltage detection means respectively connected to said first and second coupling means for providing a voltage indicative of said travelling power;
- adding means connected to the output of both voltage detection means for providing a detected voltage indicative of said travelling power and substantially insensitive of standing-wave pattern changes.

Additional features of the present invention which are believed to be novel are set forth with particularity in the appended claims.

According to the invention, the adding means is more simply a point (midpoint) of the connection between the first and the second voltage detection means. It is easily proved that this type adding means obtain the average between the two detected (rectified) voltages.

According to a preferred embodiment of the invention, said transmission line is a rectangular waveguide with a side-wall replaced by an uniform metallization on a face of a dielectric substrate fixedly connected to the waveguide, and the coupling means includes:

- two irises opened on said metallization acting as side-wall, being the irises aligned along a common line parallel to the lines of magnetic field inside the waveguide;
- two microstrips on the opposite face of dielectric substrate in respect of the uniform metallization, each microstrip intersecting a respective iris orthogonally.

This arrangement forces the microstrips to be parallel and to be spaced quarter wave apart. According to the invention, the following features are considered as profitable:

- The two microstrips cross the irises at the centre
- The two microstrips are connected to ground at one end immediately beyond the respective irises.
- The two microstrips are quarter wave long in order to show an open circuit impedance at the other end connected to the voltage detectors.
- A low-cost high loss FR4 dielectric substrate is used to obtain the metallization acting as side-wall for the waveguide and ground plane for all microstrips of the two voltage detectors.
- The dielectric substrate is tightly screwed to the metallic waveguide.
- Surface mount technology (SMT) is used to connect the diodes and the other discrete devices used in the voltage detectors.

Thanks to the invention the detected voltage at the output of the adder node only depends on the signal power conveyed by the transmission line, remaining insensitive to the standing-wave pattern whose amplitude is correlated to the mismatching value.

The advantages are evident especially when a waveguide is available for placing the power detector. In such a way couplers and/or isolators can be missed with considerable cost saving in terms of material and assembling time. Moreover the absence of detection circuits at the output of the power stage allows to minimize the path to the microstrip-waveguide transition.

## BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:

- **fig.1,** already described, indicates a RF power stage of the microwave transmitter of the prior art;
- **figures 2** and **3,** already described, indicate two conventional configurations of power detector coupled to the power stage of fig.1;
- **figures 4** and **5,** already described, indicate two possible known configurations of a directional coupler belonging to the power detector of figures 2 and 3;
- **figures 6** and **7,** already described, indicates comparative curves of coupling and directivity versus frequency of both directional couplers of figures 4 and 5;
- **fig.8A** indicates a balanced transmission line schematisation of the power detector of the present invention;
- **fig.8B** indicates a microstrip circuital schematisation embodied with hybrids of the power detector of the present invention;
- **fig.9A** indicates a waveguide circuital schematisation of the power detector of the present invention;
- **fig.9B** indicates the equivalent electrical circuit of the power detector of fig.9A;
- **fig.10** indicates a microstrip to waveguide transition at the output of the power detector of fig.9A;
- **fig.11** indicates two standing-wave patterns as detectable by two voltage detectors spaced quarter wave apart, both included in the configuration of fig.8A, 8B, 9A if a wavelength is spanned along an ideal lossless transmission line; the constant pattern summation voltage is also indicated;
- **fig.12** indicates with more detail the embodiment of the waveguides power detector of fig.9A;
- **fig.13** shows a particular of two irises included in the embodiment of fig.12;
- **fig.14** reports the curves of coupling vs .frequency referred to each iris;
- **figures 15** to **18** reports comparative curves of the voltage vs. frequency at the output of two voltage detectors and the average voltage at the summation node of the embodiment of fig.12;
- **fig.19** reports comparative curves of the detected voltage ripple amplitude (error) vs. module of reflection coefficient for two distances between the irises.

## DETAILED DESCRIPTION OF AN EMBODIMENT OF THE INVENTION

As a description rule, same elements in the drawings are referenced by the same labels, and the elements represented in the figures are not a scaled reproduction of the original ones.

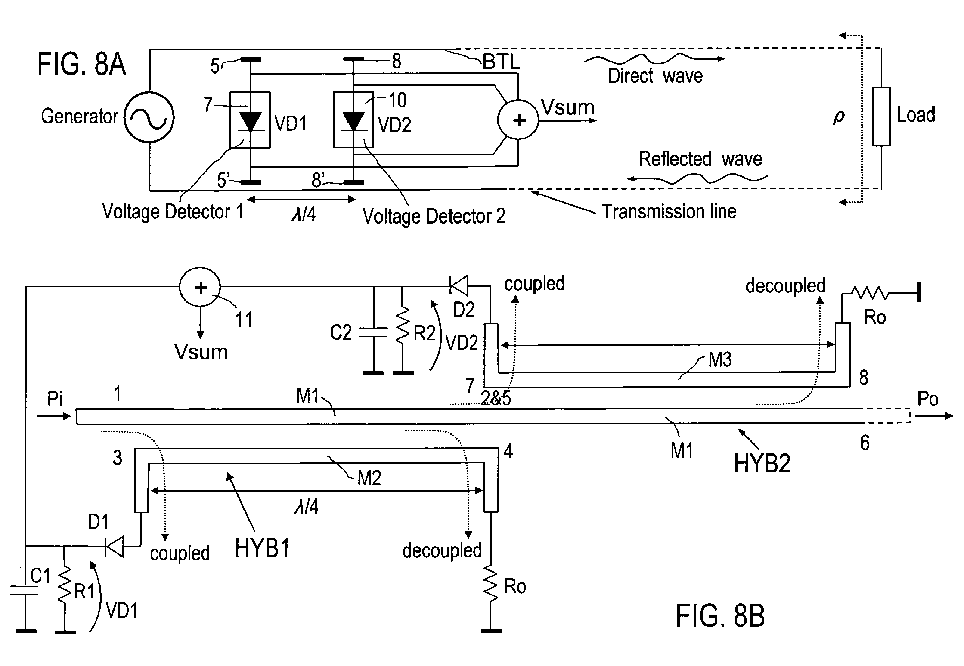

With reference to **fig.8A,** we see a balanced transmission line BTL fed by a microwave generator and terminated with a load. A power fraction of direct wave across the line is reflected by the load because of impedance mismatch, with a reflection coefficient $\rho$ depending on the entity of mismatch. Two voltage detectors 7 and 10 are capacitively or inductively coupled across the balanced transmission line at a distance of $\lambda/4$ to each other, in order to detect two quasi-constant balanced voltages VD1 and VD2 applied to the balanced inputs of an analog adder, that outputs a voltage Vsum. Capacitive coupling 5, 5' and 8, 8' are easily obtained at each cross-point between the balanced transmission line BTL and a respective connection line directed to an input of a relevant voltage detector 7 or 10. The balanced configuration of **fig.8A** can be easily modified to be used with unbalanced transmission line such as microstrips.

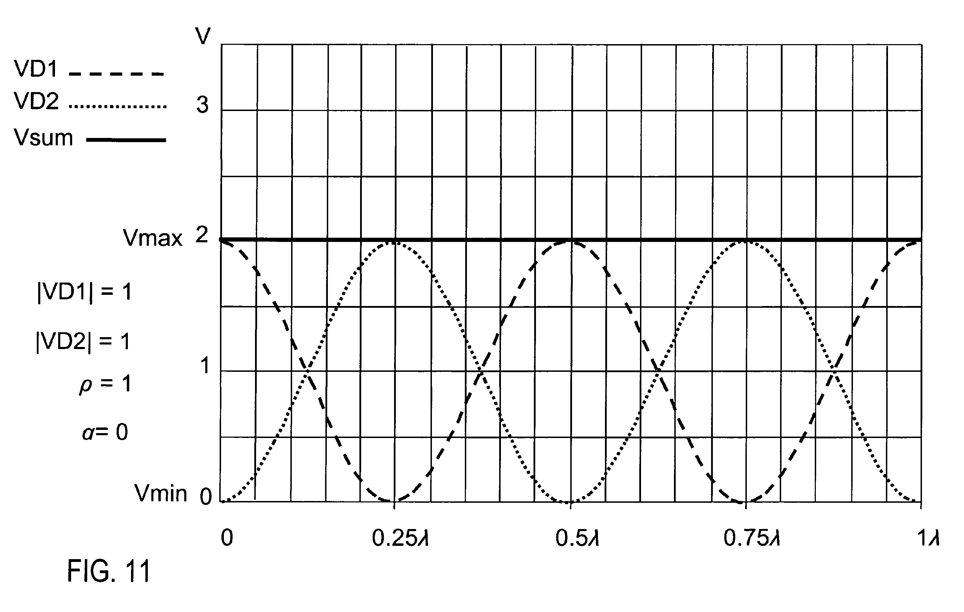

With reference to **fig.8B,** we see a microstrip M1 used to convey a microwave transmission signal from the output of a RF power stage (not shown) towards the input of a duplexer filter. Along the microstrip M1 a second quarter wave power detector similar to the one of fig.5 is replicated immediately after a first one placed nearby the output of the power stage. Replication is performed at the other side of microstrip M1 in a way that the length of the twofold structure is half wave at the central frequency of operating band. The two power detectors include two directional couplers hybrids HYB1 and HYB2. The four ports of HYB1 are numbered 1 to 4 as in fig.5. The four ports of HYB2 are numbered 5 to 8 with the same criterion adopted for HYB1. The output port 2 of HYB1 also correspond to the input port 5 of HYB1. The two hybrids are connected to two voltage detectors including Schottky diodes D1 and D2 serially connected to respective R1, C1 and R2, C2 networks. Two quasi-constant voltages VD1 and VD2 are present at the output of the two voltage detectors, the values of VD1 and VD2 depend on the dynamic of standing-wave pattern on the microstrip M1 detected at the positions corresponding to the coupled ports 3 and 7 spaced quarter wave apart. This dynamic will be discussed later on with reference to **fig.11.** Voltages VD1 and VD2 are summed up at the analog adder 11 obtaining a voltage Vsum insensible to the amplitude of standing-wave pattern, as resulting from those figures.

With reference to **fig.9A,** we see a microwave power stage 1 coupled to an end T1 of a short microstrip M having the other end T2 coupled to an end of a waveguide W used to convey the microwave transmission signal towards the other end T3 coupled to the input of a duplexer filter 2. The end T2 includes a transition between the microstrip M to the waveguide W. First coupling means 5 (inductive/capacitive iris, probe, or equivalent means) is placed to the waveguide W in proximity of the transition at T2. The coupler 5 transfers the captured microwave signal to a microstrip 6 connected to a voltage detector 7. Spaced $\lambda_g/4$ from (the centre of) coupler 5, where $\lambda_g$ is the wavelength of the fundamental propagation mode in the waveguide W, a second coupler 8 is placed to the waveguide W. The coupler 8 transfers the captured microwave signal to a microstrip 9 connected to a voltage detector 10. At the output of the two voltage detectors 7 and 10 respective voltages VD1 and VD2 are present, that are summed up by an analog adder 11, obtaining a voltage Vsum insensible to the amplitude of standing-wave pattern.

The equivalent electrical circuit of the power detector of the preceding figure is represented in **fig.9B.** With reference to the figure, the equivalent circuit comprises two voltage detectors, a first one includes a voltage generator VD1 connected in series to a resistors R1, a second one includes a voltage generator VD2 connected in series to a resistors R2 of equal value. The two voltage generators take care about the coupling voltage seen at the ends of respective resistors when the diodes are conducting. The other ends of resistors R1 and R2 are connected together. At a point of the connection between the two resistors a detected voltage Vsum is read with high impedance. Vsum corresponds to the average voltage (VD1 + VD2)/2 between VD1 and VD2; this result is independent from the concordant or discordant polarity of two diodes. It can be noticed in figure that, because of the high impedance of the reading device of the voltage Vsum, the two voltage detectors are connected in series. This is the case of an operational amplifier used to read Vsum and obtaining in the meanwhile thermal stabilization.

**Fig.10** shows in detail the microstrip to waveguide transition carried out at the microstrip end T2. With reference to the figure, we see the free end of microstrip M encircled by a metallization 12 laid down on a dielectric substrate 13 having a ground plane on the other side. Metallization 12 lets uncovered a rectangular window in correspondence of the free end of microstrip M. The ground plane faced to the rectangular window is removed for permitting to the signal travelling on the microstrip M of being irradiated towards the mouth of waveguide W faced to the rectangular window (not visible in figure). This type of transition is well known in the art and the Applicant filed some patent applications in merit.

**Fig.11** shows two curves of standing-wave pattern spanning a wavelength A of an ideal lossless transmission line in case of total reflection ($\rho$ = 1) by the load. The curves are obtained from Equation (1) applied to two voltages VD1 and VD2 detected with unitary modules at respective points spaced $\lambda/4$ apart. The detection points span with continuity values from 0 to A. The summation curve Vsum = VD1 + VD2 has a constant value of 2V.

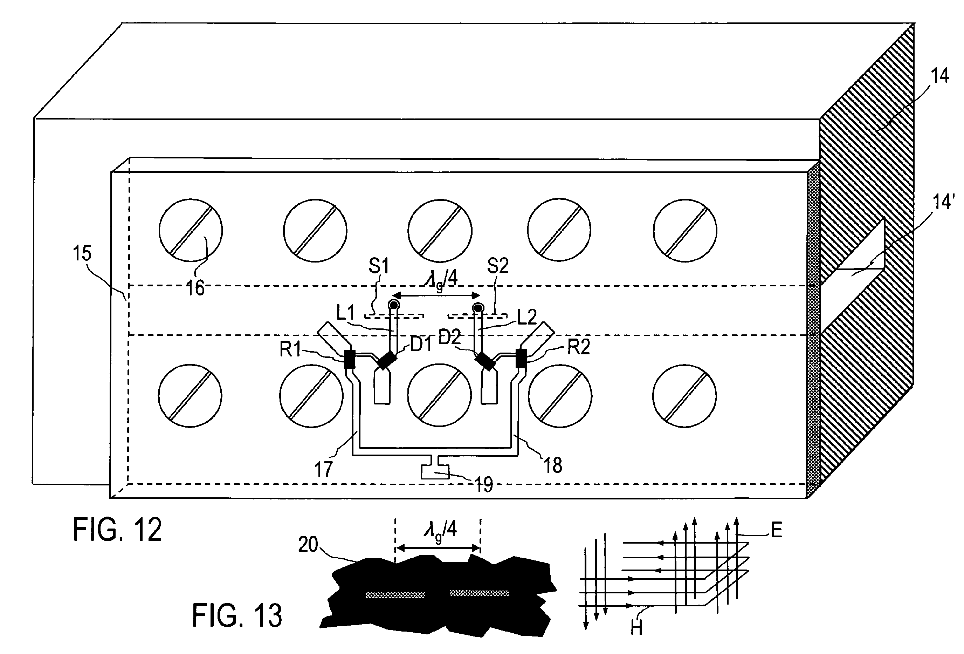

**Fig.12** shows an embodiment of the power detector of the previous **fig.9A** for a particular rectangular waveguide comprised of a metallic body 14 with a longitudinal slot 14' of rectangular cross-section, shaped as the cavity of a rectangular waveguide deprived of a side-wall, which is replaced by a uniform metallization laid down on a bottom face of a dielectric substrate 15, tightly screwed to the metallic body of waveguide 14 by means of a double row of screws 16 parallel to the longitudinal axis.

**Fig.13** shows an enlarged representation of two narrow irises S1 and S2 etched on the metallized side-wall 20 of waveguide 14. The two irises are aligned along the centre line of the side-wall with their middle points spaced $\lambda/4$ to each other at the centre of the operating frequency band. The two irises S1 and S2 are depicted in relation to the directions of electric and magnetic fields E, H inside the cavity 14' of waveguide 14. The two irises in figure are directed along the lines of the H field to obtain an inductive coupling.

With reference to **fig.12** and **13,** in an exemplary embodiment working at 15-18 GHz the two irises are 0.2 mm width and 4.5 mm long. On the upper face of dielectric substrate 15 the circuital layout of power detector is obtained using the well known printed circuit board (PCB) technology. The upper layout includes two microstrips L1 and L2, each one intersecting a respective iris S1 or S2 orthogonally, magnetically coupled to the magnetic field inside the waveguide. The intersection lines pass over the middle points of S1 and S2, thus L1 and L2 are parallel and are spaced λ/4 apart evaluated in correspondence of the central frequency of the working band. Microstrips L1 and L2 are grounded at one end immediately beyond the crossed irises S1 and S2, whereas the other end is soldered to the anode of a respective Schottky diode D1 and D2. The cathode of D1 and D2 are RF grounded by quarter-wave low-impedance open-stubs (which replace the capacitor C of figures 4 and 5 and C1, C2 of fig.8B) The length of microstrips L1 and L2 is also λ/4 so as to show an open circuit impedance on the anode of the diodes. A λ/4 line connects the cathode of diode D1 to an end of a resistor R1, the same is valid for diode D2 and a resistor R2 with the same value as R1. The other end of R1 and R2 are connected to a summing node 19 corresponding to the point of confluence of two paths 17 and 18 departing from the other end of resistor R1 and R2. Diodes and resistors are discrete devices picked and placed on the substrate and soldered using the surface mount technology (SMT). Other devices might be connected to this base scheme for thermal compensation and duplication of voltage Vsum.

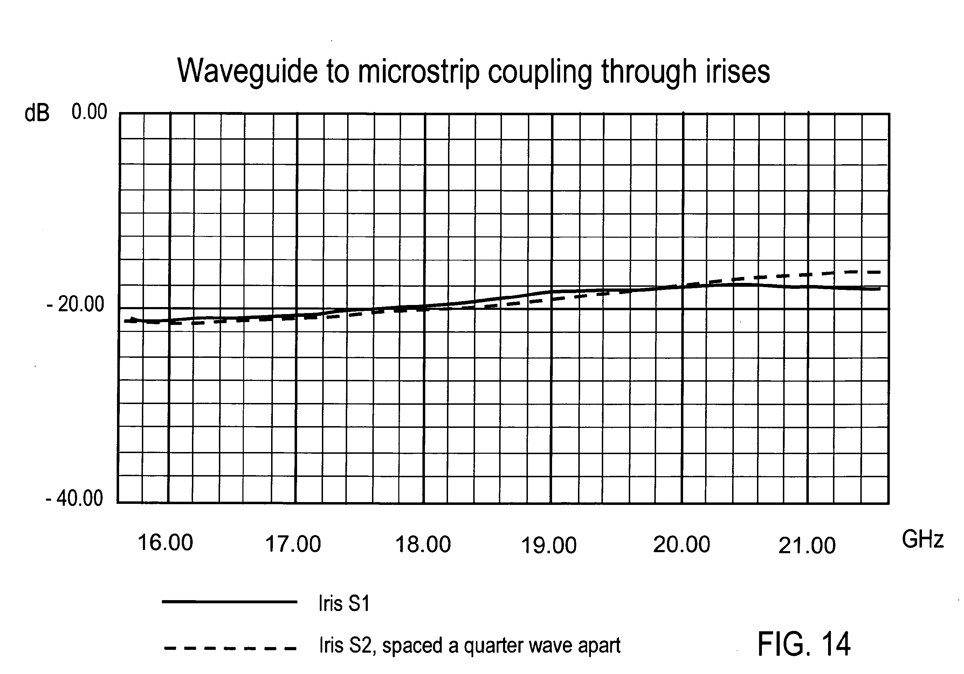

The degree of coupling between the waveguide 14 and each of the two lines L1 and L2 has been calculated (using simulation software Ansoft **HFSS**® ) and the results versus frequency are plotted in **fig.14.** Let Pi the power of microwave signal in transit through the waveguide 14, and Pacc the power captured by an iris, the coupling is calculated as: Acc=10*Log Pi/Pacc. The curves in figure show that the power captured by each iris is on the average 20 dB below the power in transit through the waveguide 14, so the power detector does not subtract significant power from the signal.

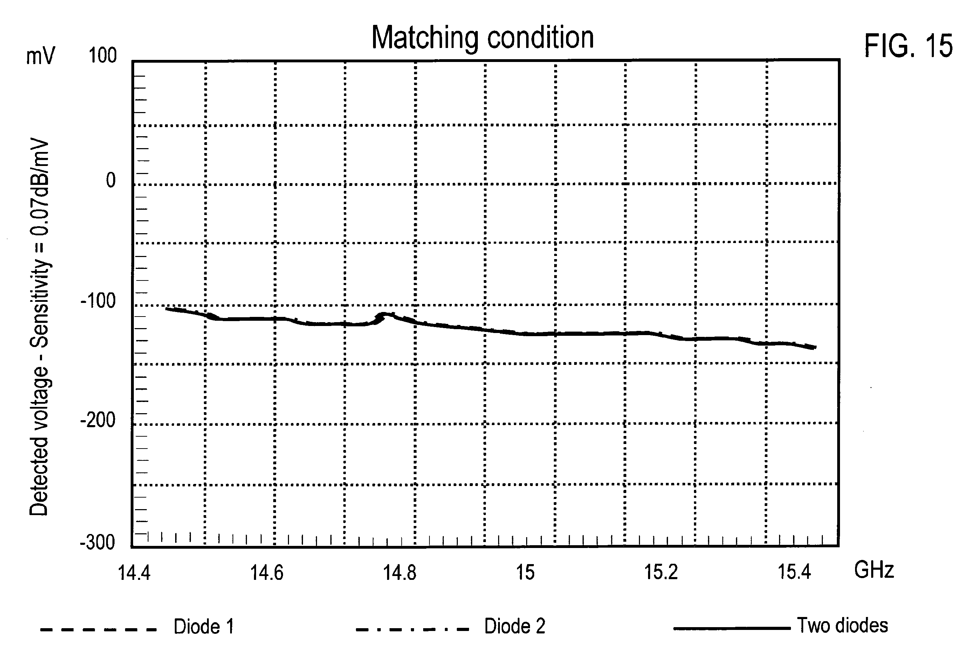

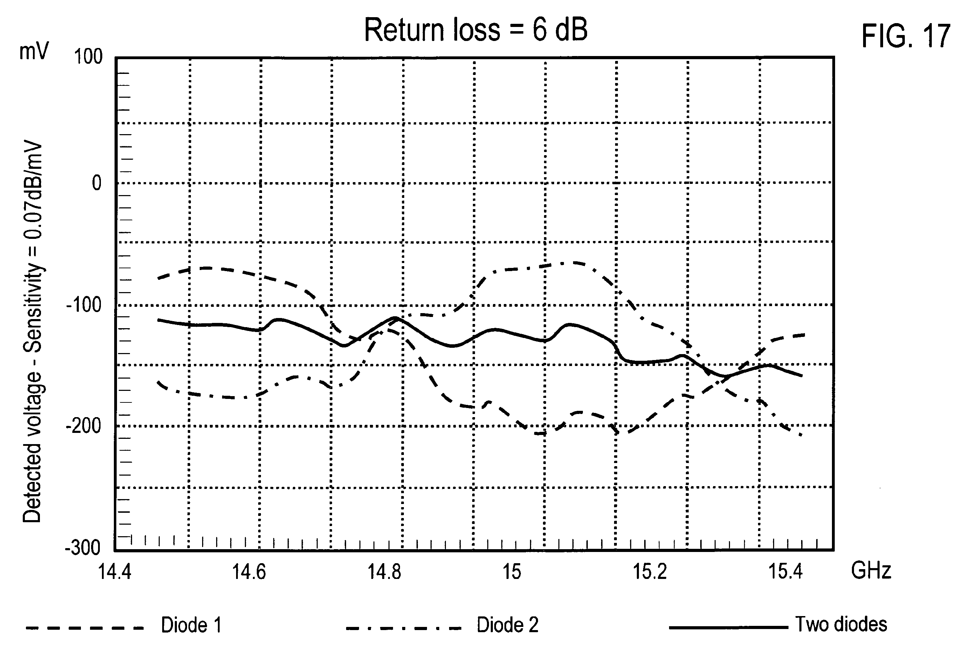

The frequency behaviour of power detector of **fig.12** has been tested manufacturing a prototype arranged as a test fixture that includes a tract of waveguide 14 (with screwed the substrate 15) between two SMA transitions screwed at the ends. One SMA port is connected to an RF signal generator, the other one is connected to different loads to obtain different return loss values. The worst-case is experimented when the output port is left open. The frequency of signal generator is varied with continuity in the range from 14.5 to 15.5GHz, corresponding to the band of interest, and in correspondence the voltage VD1, VD2, and Vsum (fig.9B) are measured. The text fixture provides relevant measuring points to be accessed from the external. The results of the measures ranked for decreasing matching conditions are shown in the successive **figures 15** to **18.**

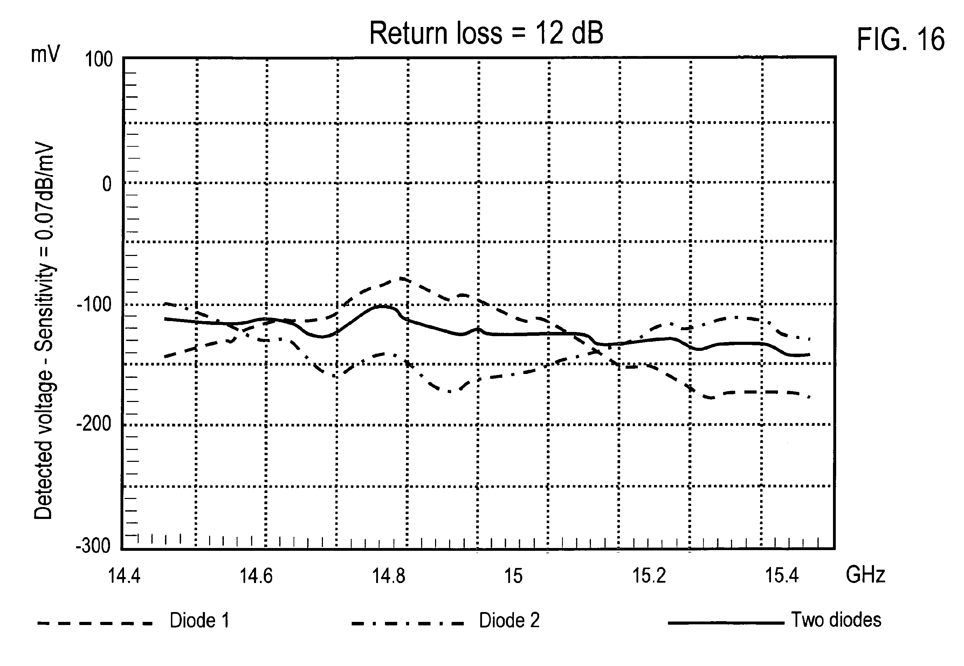

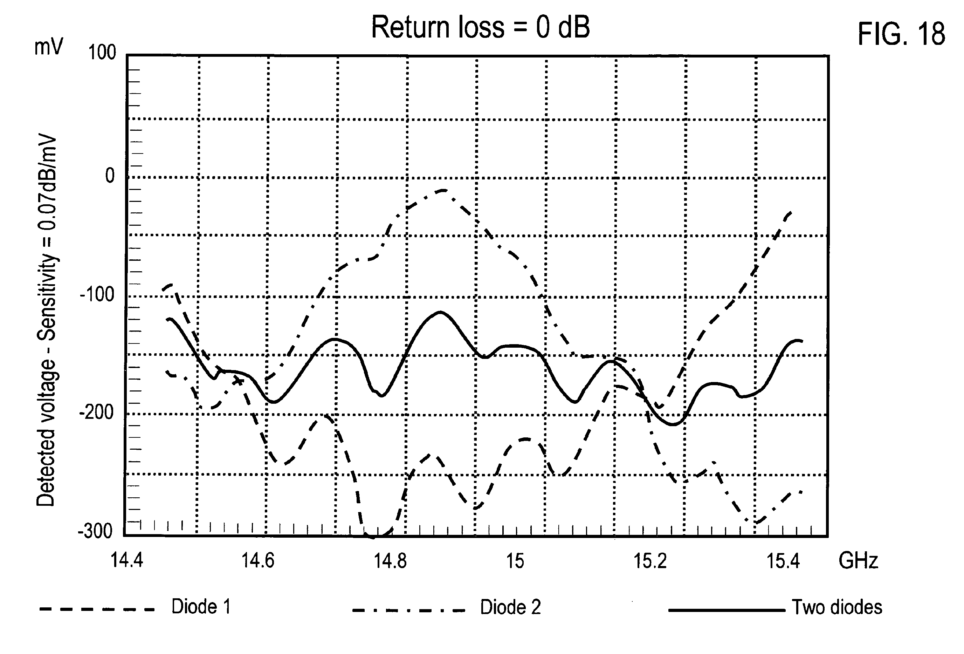

With reference to **fig.15** and **TABLE 1,** under the maximum matching condition for ρ = 0 the three curves are substantially coincident, this is in line with the average for Vsum, and the voltage Vsum is substantially flat in the band of measure. The successive **figures 16** to **18** show that despite an increasing variation of VD1 and VD2, the voltage Vsum undergoes a remarkable lower variation; this is also true for the total reflection case of **fig.18.**

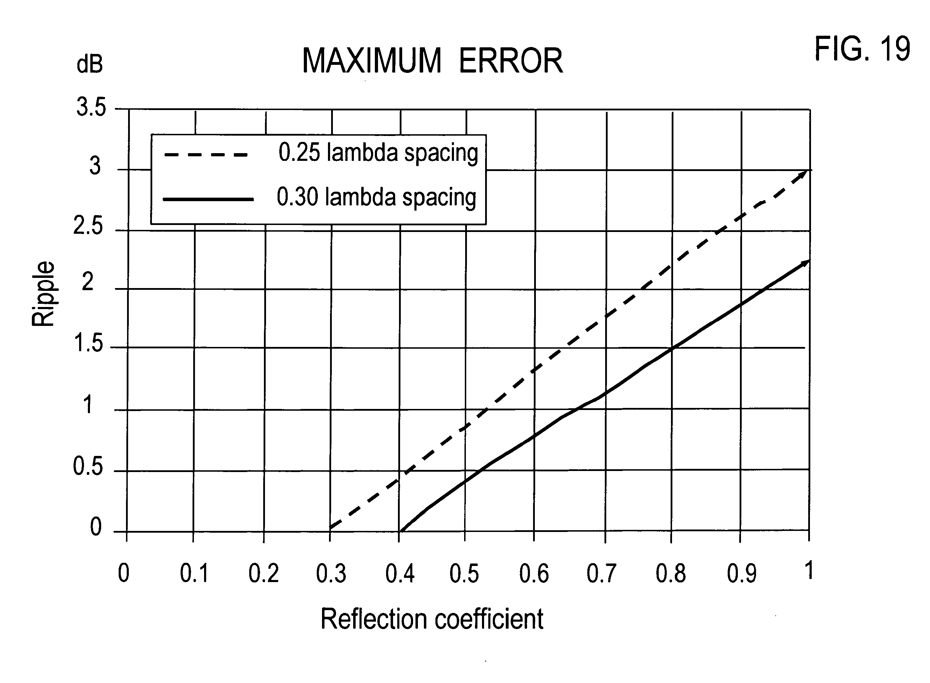

The theoretical curves represented in **fig.11** for ρ = 1 might be calculated for any other value of ρ but the conclusions should be always the same, to say, under ideal conditions (no impedance variation with frequency) the spacing of λ/4 between two detection points along the transmission line allows to obtain the sum of the two individual detected voltages the most independent as possible from the position of the two irises. Owing to non-idealities, this statement is not completely true and perhaps a separation slightly greater than λ/4 between detection points could be better. **Fig.19** is a demonstration of this fact. In this figure two curves of the ripple of Vsum (mV) over the constant value versus the reflection coefficient ρ are reported; a first curve accounts for 0.25 λ spacing and a second curve for 0.30 λ spacing. The ripple is also a measure of the maximum error in the detection. With reference to **fig.19,** we see that the second curve is always under the first one of at least 0.5 dB but for values of ρ below 0.3 the ripple is null for the two curves. This encompasses all practical cases where a good matching is required, as a consequence the importance of optimizing the spacing over λ/4 should be considered as a secondary improvement. The previous concepts are resumed in the following table.

**TABLE 2.**

| Return Loss (dB) | ρ | Standing Wave Ratio (dB) | Maximum Detector Error (dB) |
|---|---|---|---|
| 6 | 0.5 | 9.5 | 0.5 |
| 12 | 0.25 | 4.4 | 0 |
| 18 | 0.125 | 2.18 | 0 |
| 24 | 0.063 | 1.06 | 0 |

Although the invention has been described with particular reference to a preferred embodiment, it will be evident to those skilled in the art, that the present invention is not limited thereto, but further variations and modifications may be applied without departing from the scope of the claims.

## Claims

1. **1.** Microwave detector of the signal power travelling across a transmission line, including:

   - first coupling means (HYB1; S1, L1) coupled to said transmission line (M1; 14, 14', 15);
   - first voltage detection means (D1, R1) connected to said first coupling means for providing a first voltage (VD1) indicative of said travelling power,

   **characterized in that** further comprises:

   - second coupling means (HYB2; S2, L2) coupled to said transmission line at a distance from said first coupling means substantially quarter wave long at the centre of the operating frequency band;
   - second voltage detection means (D2, R2) connected to said second coupling means for providing a second voltage (VD2) indicative of said travelling power;
   - adding means (11, 19) connected to the output of both voltage detection means for providing a third voltage (Vsum) indicative of said travelling power and substantially insensitive of standing-wave pattern.

2. **2.** The microwave power detector of claim 1, **characterized in that**: said adding means (11, 19) correspond to a point of the connection between said first (D1, R1) and second (D2, R2) voltage detection means.

3. **3.** The microwave power detector of claim 2, **characterized in that** said first (D1, R1) and second (D2, R2) voltage detection means (D2, R2) each includes a Schottky diode in series to a resistor, being the central point of the series grounded at radiofrequency by a quarter-wave low-impedance open-stub.

4. **4.** The microwave power detector of any claim from 1 to 3, **characterized in that**:

   - said transmission line is a rectangular waveguide (!4, 14', 15) with a side-wall replaced by an uniform metallization (20) on a face of a dielectric substrate (15) fixedly connected (16) to the waveguide,

   and said first and second coupling means includes:

   - two irises (S1, S2) opened on said metallization acting as side-wall, being the irises aligned along a common line parallel to the lines of magnetic field inside the waveguide;
   - two microstrips (L1, L2) on the opposite face of dielectric substrate (15) in respect of the uniform metallization (20), each microstrip intersecting a respective iris orthogonally.

5. **5.** The microwave power detector of claim 4, **characterized in that** said microstrips (L1, L2) are spaced quarter wave apart.

6. **6.** The microwave power detector of claim 4 or 5, **characterized in that** said microstrips (L1, L2) cross the respective irises (S1, S2) at their centre.

7. **7.** The microwave power detector of any claim from 4 to 6, **characterized in that** said microstrips (L1, L2) are connected to ground at one end immediately beyond the respective irises (S1, S2).

8. **8.** The microwave power detector of claim 7, **characterized in that** said microstrips (L1, L2) are quarter wave long in order to show an open circuit impedance at the other end connected to said voltage detection means.

9. **9.** The microwave power detector of any claim from 4 to 8, **characterized in that** for an operating frequency band of 15-18 GHz said irises (S1, S2) are 0.2 mm width and 4.5 mm long.

10. **10.** The microwave power detector of any claim from 4 to 9, **characterized in that** said dielectric substrate (15) has high dielectric losses as the FR4 used in printed circuit board technology.

11. **11.** The microwave power detector of any claim from 4 to 10, **characterized in that** said dielectric substrate (15) is tightly screwed (16) to the rectangular waveguide (14).

12. **12.** The microwave power detector of any claim from 1 to 3, **characterized in that**:

- said transmission line is a first microstrip (M1);
- said first coupling means includes a first quarter wave directional coupler (HYB1) comprising a second microstrip (M2) parallel to the first microstrip (M1);
- said second coupling means includes a second quarter wave directional coupler (HYB2) comprising a third microstrip (M3) parallel and contiguous to the second microstrip (M2) at the other side of the first microstrip (M1).

**13.** The microwave power detector of claim 12, **characterized in that** said voltage detection means (D2, R1, D2, R2) are respectively connected to a coupled port (3, 7) of the first (HYB1) and the second (HYB2) quarter wave directional couplers.

**14.** The microwave power detector any claim from 1 to 3, **characterized in that**:

- said transmission line (BTL) is balanced;
- said first and second coupling means include capacitive coupling (5, 5'; 8, 8') at each cross-point between the balanced transmission line (BTL) and a respective connection line directed to an end of a voltage detector (7, 10) connected across the balanced transmission line (BTL);
- said adding means includes balanced inputs.

RF Power stage
Known Art
Duplexer
1
2
T1
M/W
T2
50 Ohm
Return Loss

FIG. 1

T1
3'
Known Art
T2
2
1
M/W
3
Voltage Detector
3"

FIG. 2

3'
Known Art
Circulator
1
T1
T2
2
3
M/W
4
Voltage Detector
3"

FIG. 3

Known Art
HYB
Pi
M1
Po
1
2
M2
λ/2
3
4
D1
decoupled
coupled
Ro
VD
R
C

FIG. 4

Known Art
HYB
Pi
M1
Po
1
2
M2
3
λ/4
4
D1
coupled
decoupled
C
R
VD
Ro

FIG. 5

Waveguide
Microstrip
1
T1
T2
5
W
8
T3
2
M
$\lambda_g/4$
PWD
6
7
10
9
Voltage Detector 1
Voltage Detector 2
VD1
VD2
+
11
Vsum
R1
R2
VD1
Vsum
VD2
T3
12
13
M

FIG. 9A

FIG. 9B

FIG. 10

FIG. 6

Coupling (known art)
dB
-15
-16
-17
-18
-19
-20
-21
-22
14.5
14.7
14.9
15.1
15.3
15.5 GHz
Quarter-wave coupler
Half-wave coupler

FIG. 7
Directivity (known art)
dB
35
30
25
20
15
10
5
0
-5
-10
14.5
14.7
14.9
15.1
15.3
15.5
GHz
Quarter-wave coupler
Half-wave coupler

Generator
5
7
VD1
5'
Voltage Detector 1
λ/4
8
10
VD2
8'
Voltage Detector 2
BTL
Vsum
Direct wave
Reflected wave
Transmission line
ρ
Load
11
Vsum
C2
R2
VD2
D2
coupled
decoupled
Ro
M3
7
2&5
8
Pi
1
M1
Po
M1
6
HYB2
3
4
M2
λ/4
D1
coupled
HYB1
decoupled
Ro
C1
R1
VD1

FIG. 8A

FIG. 8B

VD1
VD2
Vsum
V
3
2
1
0
Vmax
Vmin
|VD1| = 1
|VD2| = 1
ρ = 1
α= 0
0
0.25λ
0.5λ
0.75λ
1λ

FIG. 11

14
14'
15
16
17
18
19
20
S1
S2
L1
L2
D1
D2
R1
R2
$\lambda_g/4$
$\lambda_g/4$
E
H

FIG. 12

FIG. 13

Waveguide to microstrip coupling through irises
dB
0.00
- 20.00
- 40.00
16.00
17.00
18.00
19.00
20.00
21.00
GHz
Iris S1
Iris S2, spaced a quarter wave apart

FIG. 14

FIG. 15
Matching condition
mV
Detected voltage - Sensitivity = 0.07dB/mV
100
0
-100
-200
-300
14.4
14.6
14.8
15
15.2
15.4
GHz
Diode 1
Diode 2
Two diodes

FIG. 16

Return loss = 12 dB
mV
Detected voltage - Sensitivity = 0.07dB/mV
100
0
-100
-200
-300
14.4
14.6
14.8
15
15.2
15.4
GHz
Diode 1
Diode 2
Two diodes

Return loss = 6 dB
FIG. 17
mV
Detected voltage - Sensitivity = 0.07dB/mV
100
0
-100
-200
-300
14.4
14.6
14.8
15
15.2
15.4
GHz
Diode 1
Diode 2
Two diodes

Return loss = 0 dB
FIG. 18
mV
Detected voltage - Sensitivity = 0.07dB/mV
100
0
-100
-200
-300
14.4
14.6
14.8
15
15.2
15.4
GHz
Diode 1
Diode 2
Two diodes

FIG. 19
MAXIMUM ERROR
0.25 lambda spacing
0.30 lambda spacing
dB
Ripple
3.5
3
2.5
2
1.5
1
0.5
0
0
0.1
0.2
0.3
0.4
0.5
0.6
0.7
0.8
0.9
1
Reflection coefficient

European Patent Office

# EUROPEAN SEARCH REPORT

Application Number
EP 07 42 5028

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 296 146 A (CIT ALCATEL [FR]) 26 March 2003 (2003-03-26) * the whole document * ----- | 1-14 | INV. G01R1/24 G01R21/01 G01R21/10 G01R21/12 H01P5/00 |
| A | US 2005/116701 A1 (HECHTFISCHER GERD [DE] ET AL) 2 June 2005 (2005-06-02) * the whole document * ----- | 1-14 | |
| A | US 6 803 754 B2 (BRATFISCH TORALF [DE] ET AL) 12 October 2004 (2004-10-12) * the whole document * ----- | 1-14 | |

TECHNICAL FIELDS SEARCHED (IPC)

G01R
H01P

The present search report has been drawn up for all claims

| Place of search | Date of completion of the search | Examiner |
|---|---|---|
| Munich | 12 July 2007 | Dogueri, Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

3
EPO FORM 1503 03.82 (P04C01)

## ANNEX TO THE EUROPEAN SEARCH REPORT ON EUROPEAN PATENT APPLICATION NO. EP 07 42 5028

This annex lists the patent family members relating to the patent documents cited in the above-mentioned European search report.
The members are as contained in the European Patent Office EDP file on
The European Patent Office is in no way liable for these particulars which are merely given for the purpose of information.

12-07-2007

| Patent document cited in search report | Publication date | Patent family member(s) | Publication date |
|---|---|---|---|
| EP 1296146 A | 26-03-2003 | NONE | |
| US 2005116701 A1 | 02-06-2005 | DE 10205359 A1 | 21-08-2003 |
| | | DE 50301001 D1 | 22-09-2005 |
| | | WO 03067270 A1 | 14-08-2003 |
| US 6803754 B2 | 12-10-2004 | DE 10039665 A1 | 28-02-2002 |
| | | WO 0214880 A2 | 21-02-2002 |
| | | EP 1309874 A2 | 14-05-2003 |
| | | JP 2004506904 T | 04-03-2004 |
| | | US 2003020492 A1 | 30-01-2003 |



For more details about this annex : see Official Journal of the European Patent Office, No. 12/82